# EUROPEAN PATENT APPLICATION

(11) **EP 2 991 104 A2**
(43) Date of publication of application: **02.03.2016**
(21) Application number: 14185419.0
(22) Date of filing: 18.09.2014
(51) Int. Cl.: H01L 21/8258, H01L 27/06

(54) **Monolithic integrated composite group iii-v and group iv semiconductor device and ic**

(30) Priority: 29.08.2014 US 201414472974
(71) Applicant: International Rectifier Corporation, El Segundo, CA 90245 (US)
(72) Inventor: Briere, Michael A., Scottsdale, AZ Arizona 85266 (US)
(74) Representative: Dr. Weitzel & Partner

(57) **Abstract**

There are disclosed herein various implementations of a monolithic vertically integrated composite device. Such a composite device may include one or more group IV device fabricated in a group IV semiconductor body formed over a first side of a double sided substrate, and one or more group III-V device fabricated in a group III-V semiconductor body formed over a second side of the double sided substrate opposite the first side. In one implementation, the one or more group IV device may be a PN junction diode or a Schottky diode. In another implementation, the one or more group IV device may be a field-effect transistor (FET). In yet another implementation, such a composite device monolithically integrates one or more group III-V device and a group IV integrated circuit (IC). The one or more group III-V device and one or more group IV device and/or IC may be electrically coupled using one or more of a substrate via and a through-wafer via.

## Description

### RELATED APPLICATIONS

The present application is a continuation-in-part of, and claims the benefit of and priority to parent patent application entitled "Monolithic Integrated Group III-V and Group IV Device," Serial Number 14/049,564, filed on October 9, 2013, which claims priority to patent application "Method for Fabricating a Monolithic Integrated Composite Group III-V and Group IV Semiconductor Device," Serial Number 13/028,143, filed on February 15, 2011, now issued as patent number 8,557,644, which in turn claims priority to "Monolithic Vertically Integrated Composite Group III-V and Group IV Semiconductor Device and Method for Fabricating Same," Serial Number 12/455,117, filed on May 28, 2009, now issued as patent number 7,915,645. The disclosures in these applications and patents are hereby incorporated fully by reference into the present application.

### BACKGROUND

### I. DEFINITIONS

In the present application, "group III-V semiconductor" refers to a compound semiconductor that includes at least one group III element and at least one group V element, such as, but not limited to, gallium nitride (GaN), gallium arsenide (GaAs), indium aluminum gallium nitride (InA1GaN), indium gallium nitride (InGaN) and the like. Analogously, "III-Nitride semiconductor" refers to a compound semiconductor that includes nitrogen and at least one group III element, such as, but not limited to, GaN, AlGaN, InN, AlN, InGaN, InAlGaN and the like.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as silicon on insulator (SOI), separation by implantation of oxygen (SIMOX) process substrates, and silicon on sapphire (SOS), for example.

### II. BACKGROUND ART

Increased diversity in the types of materials used for semiconductor device fabrication have made integration of conventional silicon devices with more recent generations of non-silicon devices challenging. For example, although it may be highly desirable to use a silicon or other conventional group IV semiconductor device or IC ("Integrated Circuit") to control a III-Nitride transistor, doing so typically requires that the two distinct device types, each fabricated on different dies, be co-packaged, rather than share a single die in common.

However, the co-packaging of devices fabricated separately on separate dies requires more space and is more expensive than if the devices were to be integrated on a single die. In addition, the requirement that the separate dies be electrically coupled in packaging, typically by wire bonding the dies together, can introduce reliability and performance constraints flowing from the physical durability of the bonds, as well as parasitic inductances introduced by the wires themselves. Moreover, devices fabricated separately on separate dies may be less than ideally matched, resulting in sub-optimal performance of a composite device formed from the combination of such devices.

### SUMMARY

The present disclosure is directed to a monolithic integrated composite group III-V and group IV semiconductor device and integrated circuit (IC), substantially as shown in and/or described in connection with at least one of the figures, and as set forth more completely in the claims.

### BRIEF DESCRIPTION OF THE DRAWINGS

Figure 1 is a diagram showing one exemplary implementation of a monolithic vertically integrated composite group III-V and group IV semiconductor device.
Figure 2 is a flowchart presenting an exemplary method for fabricating a monolithic vertically integrated composite group III-V and group IV semiconductor device and/or integrated circuit (IC).
Figure 3 is a diagram showing a circuit corresponding to the operation of the exemplary monolithic vertically integrated composite group III-V and group IV semiconductor device of Figure 1.
Figure 4 is a diagram showing another exemplary implementation of a monolithic vertically integrated composite group III-V and group IV semiconductor device.
Figure 5 is a diagram showing a circuit corresponding to the operation of the exemplary monolithic vertically integrated composite group III-V and group IV semiconductor device of Figure 4.
Figure 6 is a diagram showing one exemplary implementation of a monolithic vertically integrated composite group III-V and group IV IC.
Figure 7 is a diagram showing a circuit corresponding to the operation of the exemplary monolithic vertically integrated composite group III-V device and IC of Figure 6.
Figure 8 is a flowchart presenting another exemplary method for fabricating a monolithic vertically integrated composite group III-V and group IV semiconductor device and/or integrated circuit (IC).

### DETAILED DESCRIPTION

The following description contains specific information pertaining to implementations in the present disclosure. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

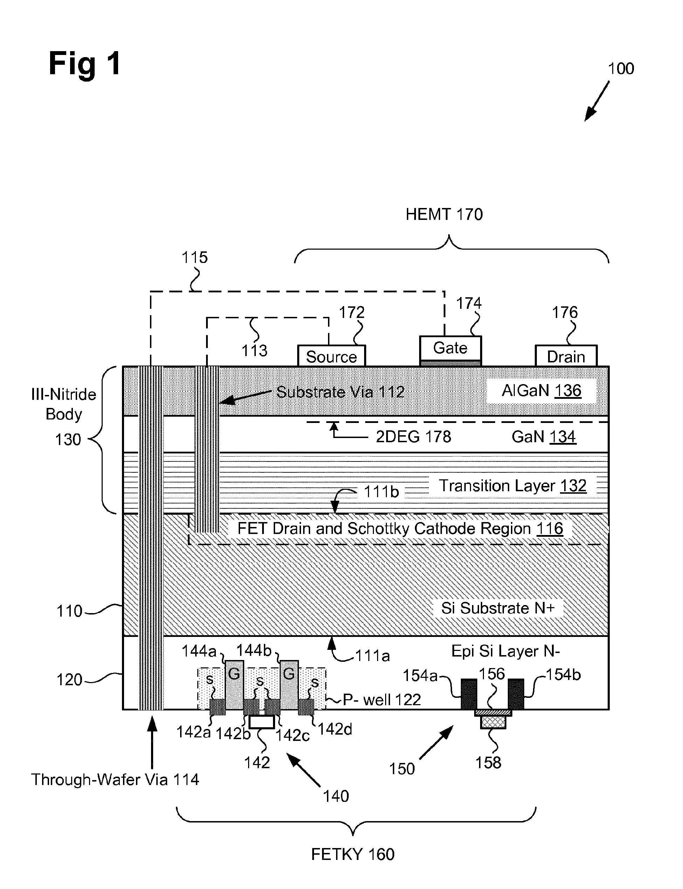

Figure 1 is a diagram showing an exemplary monolithic vertically integrated composite group III-V and group IV semiconductor device, according to one implementation. Composite structure 100 includes double sided silicon substrate 110 having first side 111a and second side 111b. Composite structure 100 further includes epitaxial silicon layer 120, which is shown to have silicon based combination field-effect transistor (FET) 140 and Schottky diode 150 (the combination of FET 140 and Schottky diode 150 also referred to as FETKY 160 in the present application). As shown in Figure 1, FETKY 160 is formed over first side 111a of silicon substrate 110. In addition, composite structure 100 includes III-Nitride semiconductor body 130 including, for the purpose of a specific example, III-Nitride high electron mobility transistor (HEMT) 170, formed over second side 111b of silicon substrate 110.

One or more metallization layers included in composite structure 100 (not shown in Figure 1), together with substrate via 112 and through-wafer via 114, electrically couple III-Nitride HEMT 170 and silicon FETKY 160. More generally, composite structure 100 may be seen to correspond to a monolithic vertically integrated composite of one or more group III-V semiconductor devices, e.g., III-Nitride HEMT 170, electrically coupled to one or more group IV semiconductor devices, e.g., silicon FETKY 160, wherein both device types share silicon substrate 110 in common.

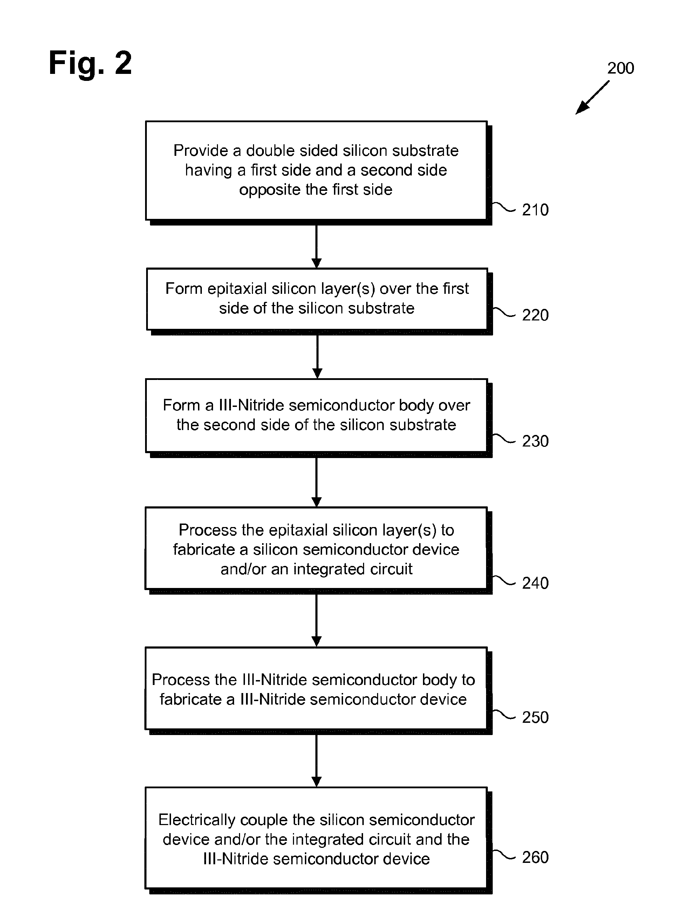

Exemplary composite structure 100 will be further described by reference to flowchart 200, in Figure 2, which describes an exemplary method for fabricating a monolithic vertically integrated composite group III-V and group IV semiconductor device and/or integrated circuit (IC). With respect to the method outlined in Figure 2, it is noted that certain details and features have been left out of flowchart 200 in order not to obscure the discussion of the inventive features in the present application. It is further noted that the processing outlined by the present exemplary method may take place at a temperature below approximately 950° C, in order to prevent decomposition of the group III-V semiconductor materials, e.g., GaN and AlGaN, used to fabricate portions of the composite device.

Flowchart 200 begins with providing double sided silicon substrate 110 having first side 111a and second side 111b opposite first side 111a (210). In one implementation, double sided silicon substrate 110 may be a finished, or polished, silicon substrate, in which case both first and second sides 111a and 111b are finished or polished sides. As shown in Figure 1, use of a double sided silicon substrate suitable for processing on both first side 111a and second side 111b assists in enabling monolithic vertical integration of the semiconductor devices formed over each respective side. Although in the implementation of Figure 1, silicon substrate 110 is shown as a unitary silicon substrate, in other implementations, silicon substrate 110 may be a silicon composite substrate, for example a double sided silicon on insulator (SOI) substrate comprising two silicon substrate layers bonded to one another by an insulator layer, for example.

Flowchart 200 continues with forming an epitaxial silicon layer or layers over first side 111a of silicon substrate 110 (220). According to the implementation shown in Figure 1, a single epitaxial silicon layer 120 is formed over first side 111a of silicon substrate 110. Formation of epitaxial silicon layer 120 may be performed by any suitable method, as known in the art, such as chemical vapor deposition (CVD) or molecular beam epitaxy (MBE), for example. As shown in Figure 1, epitaxial silicon layer 120 is shown to have N- conductivity, and to be formed over first side 111a of silicon substrate 110 having N+ conductivity. However, it is noted that the particular implementation shown in Figure 1 is merely exemplary.

More generally, formation of an epitaxial silicon layer or layers (220) corresponds to formation of any suitable group IV semiconductor body over first side 111a. Thus, in other implementations, layer 120 may correspond to more than one layer, and/or need not be formed of silicon. For example, in one implementation, layer 120 may be formed as either a strained or unstrained germanium layer formed on first side 111a of silicon substrate 110. Moreover, the conductivity type of layer 120 may be appropriately adapted according to the conductivity type of semiconductor substrate 110 and the particular semiconductor devices fabricated in layer 120.

Flowchart 200 continues with forming III-Nitride semiconductor body 130 over second side 111b of silicon substrate 110 (230). As shown in Figure 1,111-Nitride semiconductor body 130 includes a plurality of III-Nitride layers, which may include transition layer 132, gallium nitride (GaN) layer 134, and aluminum gallium nitride (AlGaN) layer 136, for example. Transition layer 132 may itself correspond to two or more distinguishable layers mediating the lattice transition from silicon substrate 110 to GaN layer 134. For example, transition layer 132 may include an aluminum nitride (AlN) layer formed on silicon substrate 110, and a series of AlGaN layers comprising progressively less aluminum and more gallium, until a suitable transition to GaN layer 134 is achieved.

The active region of III-Nitride semiconductor body 130 is represented in Figure 1 by GaN layer 134 and AlGaN layer 136, which are typically not doped, and meet to form a heterojunction interface giving rise to two-dimensional electron gas (2DEG) 178. GaN layer 134 and AlGaN layer 136 may be formed using any of a number of conventional approaches. For example, GaN layer 134 and AlGaN layer 136 may be formed using MBE, metal-organic chemical vapor deposition (MOCVD), or hydride vapor phase epitaxy (HVPE), to name a few suitable techniques. As noted previously, Figure 1 is not drawn to scale. For instance, although GaN layer 134 and AlGaN layer 136 typically have distinctly different respective thicknesses such as, for example, thicknesses of approximately 2000 Å for GaN layer 134 and of approximately 200 Å for AlGaN layer 136, those layers are shown as having comparable thicknesses in Figure 1.

Although the implementations of Figure 1 and flowchart 200 refer to III-Nitride body 130, more generally, body 130 may be formed from any suitable group III-V semiconductor materials, as described in the "Definitions" section above. Typically, the primary constraints placed upon the constituents of body 130 are that layer 136 be formed of a group III-V semiconductor having a wider band gap than the group III-V semiconductor forming layer 134, that both group III-V semiconductors be selected so as to produce 2DEG 178, and that transition layer 132 provide a suitable foundation for growth of group III-V semiconductor layer 134.

In some implementations, formation of a group III-V semiconductor body, e.g., III-Nitride semiconductor body 130, over second side 111b of silicon substrate 110 (230) concludes by coating III-Nitride semiconductor body 130 with a capping layer (not shown in Figure 1). A suitable material for application as a capping layer can be silicon nitride or GaN, for example, provided to seal and protect AlGaN layer 136 during subsequent group IV, e.g., silicon, processing.

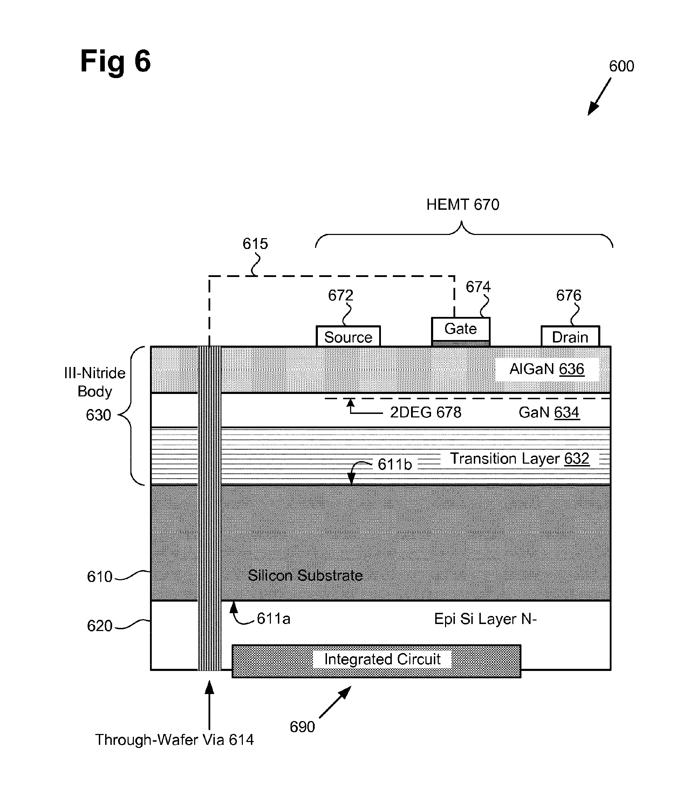

Referring once again to Figure 2, flowchart 200 (at 240) continues with processing of the epitaxial silicon layer or layers to fabricate a semiconductor device, such as silicon FETKY 160, and/or an IC, for example, IC 690 in Figure 6. According to the implementation of Figure 1, such processing corresponds to formation of FET 140 and Schottky diode 150, which are shown as trench type devices, and that, in combination, produce FETKY 160 in epitaxial silicon layer 120. However, as will be described in greater detail below by reference to Figure 6, in one implementation, epitaxial layer 120 can be processed to fabricate an IC.

Fabrication of a trench FET, such as FET 140, in Figure 1, is known in the art. Without delving into extensive detail, it is noted that fabrication of FET 140 may include forming P- well 122 in epitaxial silicon layer 120, forming gate trenches 144a and 144b, lining gate trenches 144a and 144b with a suitable material, filling gate trenches 144a and 144b with, for example, polysilicon, doping the polysilicon fill, and implanting source regions 142a, 142b, 142c, and 142d. As known in the art and indicated in Figure 1, a portion of silicon substrate 110 adjacent to second side 111b serves as drain region 116 for FET 140.

Fabrication techniques for producing trench Schottky diode 150 are also known in the art. Such techniques are described in, for example, U.S. Patent Application Number 6,855,593 to Andoh et al., and U.S. Patent Application Number 6,977,208 to Chiola, both of which are presently assigned to the assignee of the present application, and the disclosures of which are hereby incorporated fully by reference into the present application. Again, without delving into extensive detail, it is noted that fabrication of Schottky diode 150 may include forming diode trenches 154a and 154b in epitaxial silicon layer 120, lining diode trenches 154a and 154b with a suitable material, such as an oxide liner, filling diode trenches 154a and 154b with, for example, polysilicon, doping the polysilicon fill, and forming Schottky anode barrier 156 using titanium or titanium tungsten for example. As indicated in Figure 1, the same portion of silicon substrate 110 adjacent to second side 111b serving as drain region 116 for FET 140 also serves as cathode region 116 for Schottky diode 150.

In some implementations, fabrication of one or more silicon or other group IV semiconductor devices and/or IC, for example, IC 690 in Figure 6, concludes by covering the group IV semiconductor active layer, e.g. epitaxial silicon layer 120, with a capping layer (not shown in Figure 1). A suitable material for application as a capping layer can be an oxide, for example, provided to seal and protect epitaxial silicon layer 120 during subsequent processing of the group III-V semiconductor body, e.g., III-Nitride semiconductor body 130. It is noted that it may be advantageous for the capping materials selected for use in protecting respective group IV semiconductor active layer 120 and the group III-V semiconductor layer represented by AlGaN layer 136 be different from one another. For example, utilizing different capping materials permits removal of either one of the capping layers without compromising the protection provided by the other.

Flowchart 200 continues with processing III-Nitride semiconductor body 130 to fabricate, for example, III-Nitride HEMT 170 (250). Fabrication of III-Nitride HEMT 170 may include first stripping or otherwise modifying the protective nitride capping layer formed over AlGaN layer 136. In some embodiments, the protective layer is a combination of a field dielectric (for example silicon nitride) which will become part of the finished device and a sacrificial film (for example siliocn oxide) which will be removed after its protective function is completed. Fabrication of III-Nitride HEMT 170 may then proceed through formation of a field insulation or passivation layer, completion of a device isolation process, the opening of active and contact regions for III-Nitride HEMT 170, the formation of gate dielectrics and electrodes, the formation of ohmic contacts and so forth, as known in the art.

Following fabrication of the group IV and group III-V devices, electrical interconnects for composite structure 100 are formed. Thus, flowchart 200 continues with electrically coupling silicon FETKY 160 and III-Nitride HEMT 170. According to the implementation shown in Figure 1, electrically coupling the group IV and group III-V devices includes formation of substrate via 112 and through-wafer via 114, as well as establishment of interconnects to the HEMT source 172, HEMT gate 174, HEMT drain 176, FET source 142 and Schottky anode 158.

It is noted that in the present implementation, HEMT source 172, HEMT drain 176, and FET source 142 are represented as having ohmic contacts, while Schottky anode 158 provides a Schottky contact with Schottky diode 150. Moreover, as shown in Figure 1, HEMT gate 174 may include a gate metal on an insulating body or make a Schottky contact with III-Nitride semiconductor body 130. Moreover, although not shown in Figure 1, FET source 142, or an additional FET source not shown, can provide electrical contact to FET source regions 142a and 142d, in addition to providing electrical contact to FET source regions 142b and 142c, which is explicitly shown in Figure 1.

As explained above, electrical interconnections in composite structure 100 may be provided by metallization layers not shown in Figure 1, and the vias formed in composite structure 100. Those vias include substrate via 112 and through-wafer via 114, which may be insulated from the group III-V and group IV layers through appropriate doping or the formation of dielectric sidewall layers in substrate via 112 and through-wafer via 114, for example (via insulation not shown in Figure 1). Although only one representation of each of substrate via 112 and through-wafer via 114 is shown in Figure 1, it is understood that composite structure 100 may include multiple instances of one or both of substrate via 112 and through-wafer via 114 to, for example, provide additional connection points and options, improve current carrying capability, and to reduce inductance and resistance associated with these vias. In other implementations, the connection between the group IV device (s) or IC and one or more of the III-N device(s) can be made through external means, such as in a package, using methods, for example, such as clips, ribbins, wirebonds or leadframes.

FETKY 160 is formed through the parallel arrangement of FET 140 and Schottky diode 150. Electrical interconnects not explicitly shown in Figure 1 provide electrical coupling between FET source 142 and Schottky anode 158. It is noted that substrate via 112 terminates in region 116, which serves as both a drain region for FET 140 and a cathode region for Schottky diode 150. Moreover, in exemplary composite structure 100, HEMT source 172 is electrically coupled to FET drain and Schottky cathode region 116 of FETKY 160 through substrate via 112, as represented by conceptual connection 113. In addition, HEMT gate 174 is electrically coupled to both FET source 142 and Schottky anode 158 by means of through-wafer via 114, as represented by conceptual connection 115, thus completing fabrication of exemplary monolithic vertically integrated composite structure 100.

It is noted that in one implementation, composite structure 100 may omit one of FET 140 or Schottky diode 150. That is to say, one alternative implementation of composite structure 100 may provide monolithic vertical integration of a group III-V device, such as III-Nitride HEMT 170, with a group IV Schottky diode, such as silicon Schottky diode 150. In that implementation, anode 158 may be electrically coupled to HEMT gate 174 by through-wafer via 114, while Schottky cathode region 116 may be electrically connected to HEMT source 172 by substrate via 112. Moreover, in another implementation, composite structure 100 may provide monolithic vertical integration of III-Nitride HEMT 170 with silicon FET 140. In that latter implementation, FET source 142 may be electrically coupled to HEMT gate 174 by through-wafer via 114, while FET drain region 116 may be electrically connected to HEMT source 172 by substrate via 112. As discussed in Figure 1, in other implementations, the connection between one or more of the group IV devices and the III-N device can be made through external means, such as in a package, using methods, for example, such as clips, ribbins, wirebonds or leadframes. It is also noted that there may also be one or more III-Nitride HEMTs connected to one or more group IV devices.

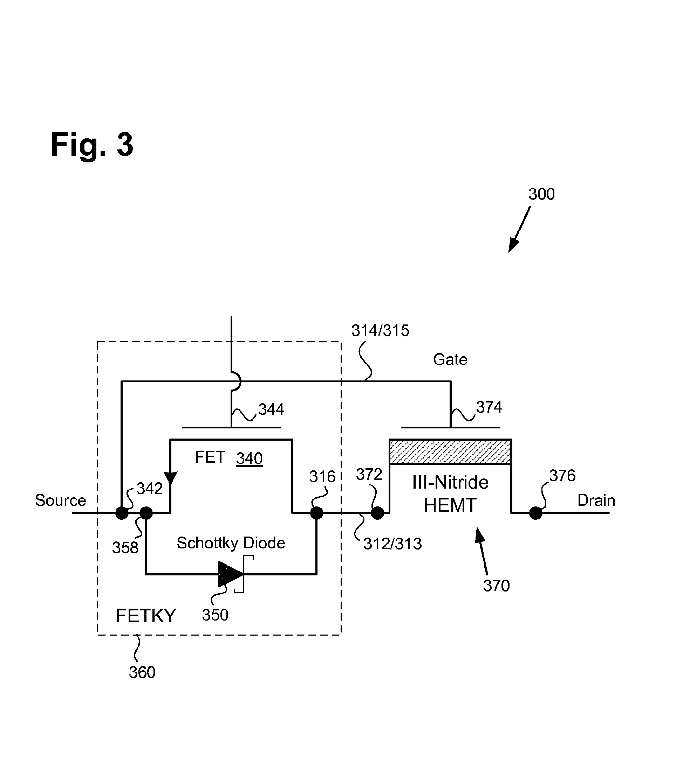

The operational advantages of monolithic vertically integrated composite structure 100 may be more clearly appreciated by reference to Figure 3, which shows a diagram of a corresponding circuit. Circuit 300, in Figure 3, shows FETKY 360 coupled to III-Nitride HEMT 370. As shown in Figure 3, FETKY 360 includes FET 340 including source 342, and gate 344, as well as Schottky diode 350 including Schottky anode 358, which correspond respectively to FETKY 160 including FET 140 having FET source regions 142a, 142b, 142c, and 142d, and gate trenches 144a and 144b, and Schottky diode 150 including Schottky anode 158, in Figure 1. Figure 3 also shows that the drain of FET 340 and the cathode of Schottky diode 350 are coupled at node 316, corresponding to shared FET drain and Schottky cathode region 116, in Figure 1.

III-Nitride HEMT 370, in Figure 3, includes HEMT source 372, HEMT gate 374, and HEMT drain 376, corresponding respectively to HEMT source 172, HEMT gate 174, and HEMT drain 176, in Figure 1. Circuit 300, in Figure 3, further shows electrical connections 312/313 and 314/315 providing electrical coupling of FETKY 360 to III-Nitride HEMT 370. Electrical connections 312/313 and 314/315 correspond respectively to substrate via 112/conceptual connection 113, and through-wafer via 114/conceptual connection 115, electrically coupling silicon FETKY 160 and III-Nitride HEMT 170, in Figure 1. Consistent with the previous description of the interconnections provided by respective substrate via 112 and through-wafer via 114 in Figure 1, circuit 300 shows HEMT source 372 coupled to FET drain and Schottky cathode node 316 by electrical connection 312/313, and shows HEMT gate 374 coupled to FET source 342 and Schottky anode 358 by electrical connection 314/315.

As shown in Figure 1, 2DEG 178 may be continuous under HEMT gate contact 174, indicating that III-Nitride HEMT 170, corresponding to III-Nitride HEMT 370, is a depletion mode device having a "normally ON" state. Concurrent reference to composite structure 100, in Figure 1, and circuit 300, in Figure 3 reveals that the present implementation enables use of a cascoded silicon FET 340, anti-parallel Schottky diode clamp 350 (also referred to as "anti-parallel clamp" in short) and depletion mode III-Nitride HEMT 370 such that the combination of the three devices (i.e. the combination of FETKY 360 and depletion mode III-Nitride HEMT 370) behaves as an enhancement mode (i.e. "normally OFF") switch. In other words, gate 344, source 342, and HEMT drain 376 behave, respectively, as the gate, source, and drain of the resulting composite enhancement mode switch. One advantage of such an arrangement is that a low voltage silicon FETKY device comprised of low voltage FET 340 and anti-parallel diode clamp 350 can be used in high voltage applications with a power HEMT device, while retaining desirable low voltage silicon FET and anti-parallel Schottky diode clamp characteristics, such as low charge storage, clamping and good reverse recovery characteristics.

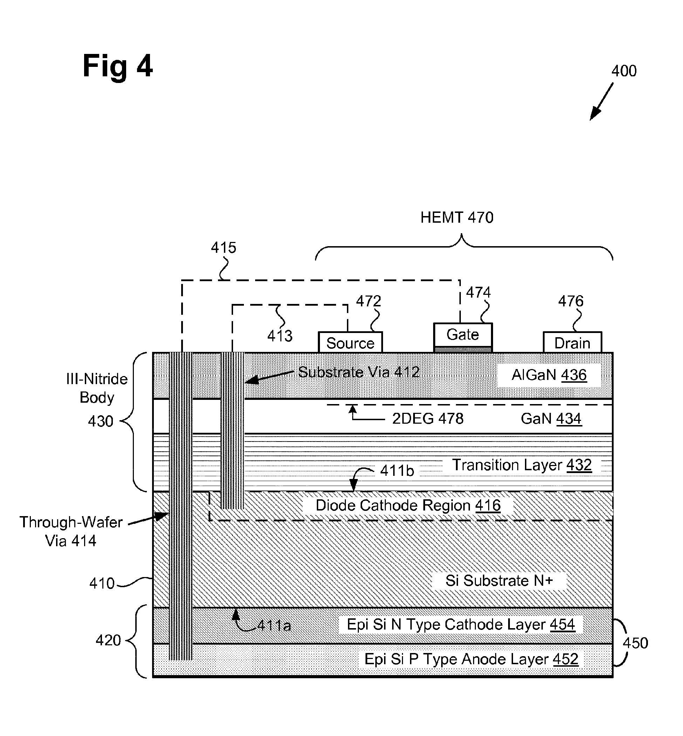

It is noted that Figures 1 and 3 are exemplary implementations and although Figure 1 shows a continuous 2DEG 178 under gate 174 and representing a depletion mode HEMT, enhancement mode HEMTs may also be used and as such, 2DEG 178 may be interrupted or discontinuous under gate 174 and as such will exhibit a "normally OFF" characteristic. Referring now to Figure 4, Figure 4 is a diagram showing an exemplary monolithic vertically integrated composite group III-V and group IV semiconductor device, according to another implementation. Composite structure 400 includes double sided silicon substrate 410 having first side 411a and second side 411b. Composite structure 400 further includes silicon body 420 having PN junction diode 450 formed therein. PN junction diode 450 includes P type epitaxial silicon anode layer 452 and N type epitaxial silicon cathode layer 454. As shown in Figure 4, PN junction diode 450 is formed over first side 411a of silicon substrate 410. Composite structure 400 also includes III-Nitride semiconductor body 430 including transition layer 432, GaN layer 434, and AlGaN layer 436 providing III-Nitride HEMT 470 including 2DEG 478. III-Nitride semiconductor body 430 is formed over second side 411b of silicon substrate 410. Also shown in Figure 4 are diode cathode region 416, substrate via 412, through-wafer via 414, conceptual connections 413 and 415, HEMT source 472, HEMT gate 474, and HEMT drain 476.

Composite structure 400 corresponds in general to composite structure 100, in Figure 1. Double sided silicon substrate 410, and III-Nitride body 430 including transition layer 432, GaN layer 434, and AlGaN layer 436 correspond respectively to double sided silicon substrate 110, and III-Nitride body 130 including transition layer 132, GaN layer 134, and AlGaN layer 136, in Figure 1. In addition, substrate via 412, conceptual connections 413 and 415, and III-Nitride HEMT 470 including HEMT source 472, HEMT gate 474, HEMT drain 476, and 2DEG 478, in Figure 4, correspond respectively to substrate via 112, conceptual connections 113 and 115, and III-Nitride HEMT 170 including HEMT source 172, HEMT gate 174, HEMT drain 176, and 2DEG 178, in Figure 1. Moreover, through-wafer via 414, diode cathode region 416, and silicon body 420, in Figure 4, are analogous to through wafer via 114, FET drain and Schottky cathode region 116, and epitaxial silicon layer 120, in Figure 1. It is noted that, unlike the implementation shown in Figure 1, in the present implementation, through-wafer via 414 terminates in anode layer 452 of PN junction diode 450. One of ordinary skill in the art will recognize that the exemplary method shown by flowchart 200, in Figure 2, can be readily adapted to produce composite structure 400, in Figure 4.

PN junction diode 450 includes anode layer 452 and cathode layer 454. According to the exemplary implementation shown in Figure 4, anode layer 452 is a P type epitaxial silicon layer, while cathode layer 454 is an N type epitaxial layer. More generally, however, PN junction diode 450 may be implemented using any suitable combination of group IV layers, which may or may not be epitaxially grown, as anode layer 452 and cathode layer 454. As further shown in Figure 4, according to the present implementation, anode layer 452 may be electrically coupled to HEMT gate contact 474 by through-wafer via 414, as shown by conceptual connection 415. In addition cathode layer 454 may be electrically connected to diode cathode region 416 through the drift region provided by N+ silicon substrate 110, while diode cathode region may be electrically connected to HEMT source 472 by substrate via 412, as shown by conceptual connection 413. Alternatively, in one implementation, substrate via 412 may be implemented as a through-wafer via terminating in cathode layer 454 so as to electrically couple cathode layer 454 and HEMT source 472.

As disccused previously, although Figure 4 shows the use of substrate vias and through wafer vias to electically connect the III-Nitirde and group IV devices, in other implementations, the connection between one or more of the group IV devices and the III-N device can be made through external means, such as in a package, using methods, for example, such as clips, ribbins, wirebonds or leadframes. It is also noted that there may also be one or more III-Nitride HEMTs connected to one or more group IV devices.

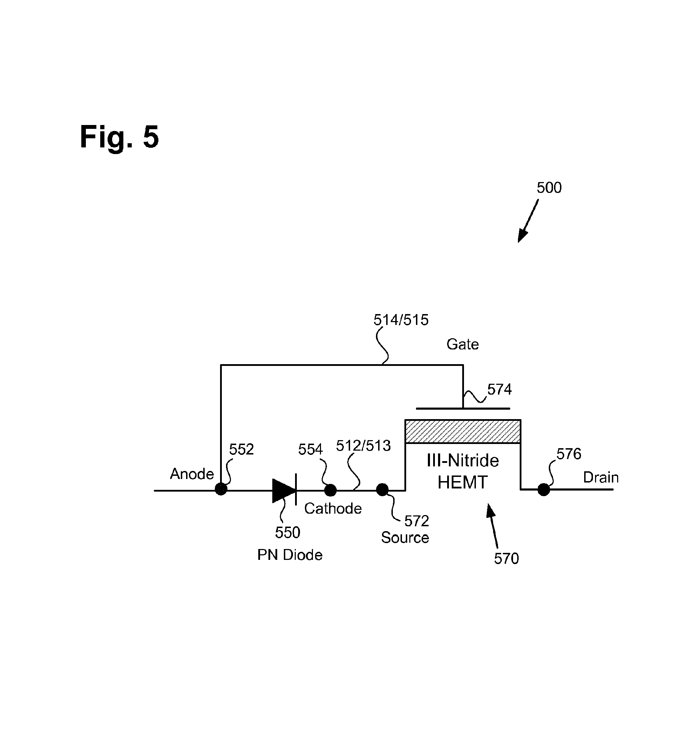

Figure 5 is a diagram showing a circuit corresponding to the operation of the exemplary monolithic vertically integrated composite group III-V and group IV semiconductor device of Figure 4. Circuit 500, in Figure 5, shows PN junction diode 550 coupled to III-Nitride HEMT 570. As shown in Figure 5, PN junction diode 550 includes anode 552 and cathode 554, and corresponds respectively to PN junction diode 450 including anode layer 452 and cathode layer 454, in Figure 4.

III-Nitride HEMT 570, in Figure 5, includes HEMT source 572, HEMT gate 574, and HEMT drain 576, corresponding respectively to HEMT source 472, HEMT gate 474, and HEMT drain 476 of III-Nitride HEMT 470, in Figure 4. Circuit 500, in Figure 5, further shows electrical connections 512/513 and 514/515 providing electrical coupling of PN junction diode 550 and III-Nitride HEMT 570. Electrical connections 512/513 and 514/515 correspond respectively to substrate via 412/conceptual connection 413, and through-wafer via 414/conceptual connection 415, electrically coupling PN junction diode 450 and III-Nitride HEMT 470, in Figure 4. Consistent with the previous description of the interconnections provided by respective through-wafer via 414 and substrate via 412 in Figure 4, circuit 500 shows anode 552 of PN junction diode 550 coupled to HEMT gate 574 by electrical connection 514/515, and shows cathode 554 of PN junction diode 550 coupled to HEMT source 572 by electrical connection 512/513.

According to another exemplary implementation of the monolithic vertically integrated composite group III-V and group IV semiconductor device, including a III-V transistor and antiparallel group IV PN junction diode, the group IV PN junction diode 450 can alternatively be coupled across III-Nitride HEMT 470 (not shown). That is to say anode 552 of PN junction diode 550 can be coupled to source contact 572 of III-Nitride HEMT 570, and cathode 554 of PN junction diode 550 can be coupled to drain contact 576 of III-Nitride HEMT 570. This may be a preferred configuration to electrically connect the group III-V and group IV devices if the PN junction diode is to be used as a clamp for the III-Nitride HEMT rather than configure the two devices in a cascoded arrangement as described in Figures 1, 3, 4 and 5.

Continuing to Figure 6, Figure 6 is a diagram showing one exemplary implementation of a monolithic vertically integrated composite group III-V device and group IV IC. Composite structure 600 includes double sided silicon substrate 610 having first side 611a and second side 611b. Composite structure 600 further includes epitaxial silicon layer 620 having IC 690 formed therein. As shown in Figure 6, epitaxial silicon layer 620 including IC 690 is formed over first side 611a of silicon substrate 610.

Composite structure 600 also includes III-Nitride semiconductor body 630 including transition layer 632, GaN layer 634, and AlGaN layer 636 providing III-Nitride HEMT 670 including 2DEG 678. III-Nitride semiconductor body 630 is formed over second side 611b of silicon substrate 610. Also shown in Figure 6 are through-wafer via 614, conceptual connection 615, HEMT source 672, HEMT gate 674, and HEMT drain 676.

Composite structure 600 corresponds in general to composite structure 100, in Figure 1. Double sided silicon substrate 610, and III-Nitride body 630 including transition layer 632, GaN layer 634, and AlGaN layer 636 correspond respectively to double sided silicon substrate 110, and III-Nitride body 130 including transition layer 132, GaN layer 134, and AlGaN layer 136, in Figure 1. In addition, through-wafer via 614, conceptual connection 615, and III-Nitride HEMT 670 including HEMT source contact 672, HEMT gate contact 674, HEMT drain contact 676, and 2DEG 678, in Figure 6, correspond respectively to through-wafer via 114, conceptual connection 115, and III-Nitride HEMT 170 including HEMT source contact 172, HEMT gate contact 174, HEMT drain contact 176, and 2DEG 178, in Figure 1. Moreover, epitaxial silicon layer 620, in Figure 6, corresponds to epitaxial silicon layer 120, in Figure 1. One of ordinary skill in the art will recognize that the exemplary method shown by flowchart 200, in Figure 2, can be suitably adapted to produce composite structure 600, in Figure 6.

IC 690 may be a driver IC, for example, implemented to drive one or more III-Nitride HEMTs 670 by providing drive signals to HEMT gate 674. One or more metallization layers included in composite structure 600 (not shown in Figure 6), together with through-wafer via 614, can be used to electrically couple an output of IC 690 to HEMT gate 674, as represented by conceptual connection 615.. In other implementations, the connection between the group IV device or IC and one or more of the III-N device(s) can be made through external means, such as in a package, using methods, for example, such as clips, ribbins, wirebonds or leadframes.

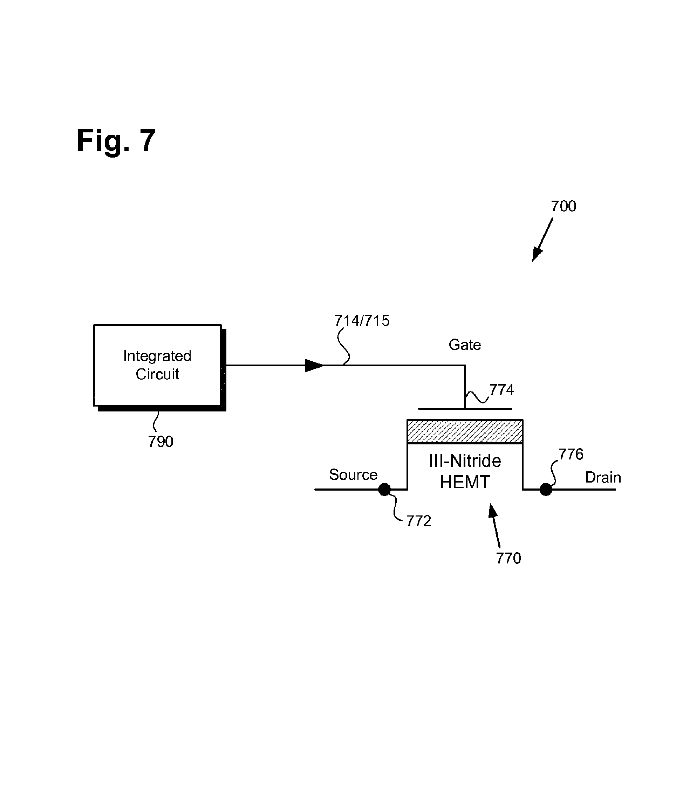

Figure 7 is a diagram showing a circuit corresponding to the operation of such a monolithic vertically integrated composite group III-V device and group IV IC.

Circuit 700, in Figure 7, shows IC 790 coupled to III-Nitride HEMT 770. III-Nitride HEMT 770 and IC 790 correspond respectively to III-Nitride HEMT 670 and IC 690, in Figure 6. III-Nitride HEMT 770 includes HEMT source 772, HEMT gate 774, and HEMT drain 776, corresponding respectively to HEMT source 672, HEMT gate 674, and HEMT drain 676, in Figure 6. Circuit 700, in Figure 7, further shows electrical connection 714/715 providing electrical coupling of IC 790 and III-Nitride HEMT 770. Electrical connection 714/715 corresponds to through-wafer via 614/conceptual connection 615 electrically coupling IC 690 and III-Nitride HEMT 670, in Figure 6.

The group IV IC may include several integrated power management functions including for example, a gate driver IC for one or more of the group III-V transistors or switches, level shift circuitry, protection circuitry for over-current, under-voltage, thermal stress and output shorts, logic circuits and PWM functionality, DC enable switch and associated circuitry, and controllers, filters, etc. As such, the group IV IC is used to control the conductive state of at least one group III-V device through modulation of the voltage applied to the group III-V device gate electrodes.

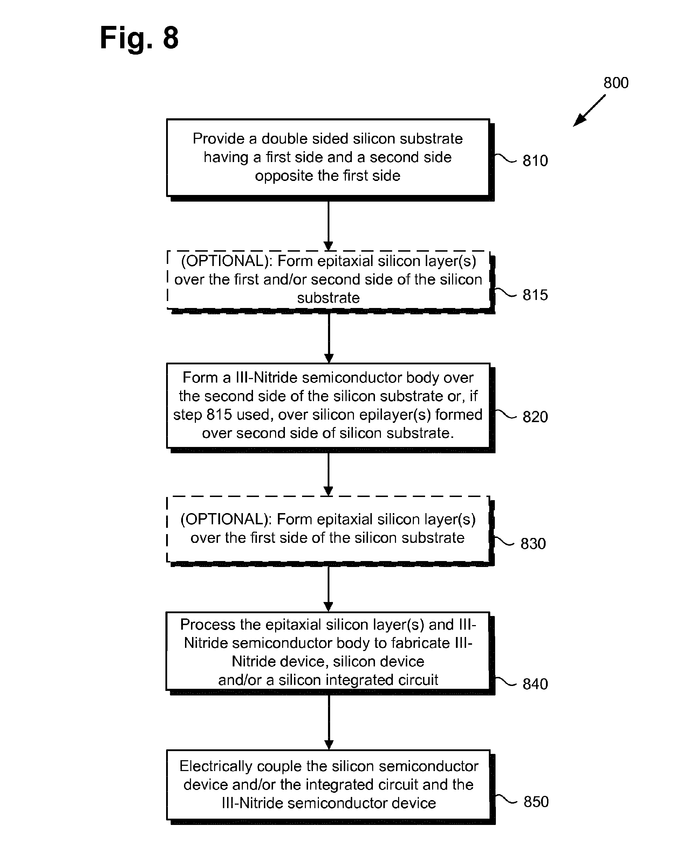

As one of many alternative methods (within the scope of the present inventive concepts) to that shown in Figure 2, exemplary method 800 for fabricating a monolithic vertically integrated composite group III-V and group IV semiconductor device and/or integrated circuit (IC) is shown in Figure 8. With respect to the method outlined in Figure 8, it is noted that certain details and features have been left out of flowchart 800 in order not to obscure the discussion of the inventive features in the present application. It is further noted that the processing outlined by exemplary method 800 may take place at a temperature below approximately 950° C, in order to prevent decomposition of the group III-V semiconductor materials, e.g., GaN and AlGaN, used to fabricate portions of the composite device.

Flowchart 800 begins with action 810 providing double sided silicon substrate 110 having first side and second side opposite first side. In one implementation, the double sided silicon substrate may be a finished, or polished, silicon substrate, in which case both first and second sides are finished or polished sides. In other implementations, the double sided silicon substrate may be a silicon composite substrate, for example a double sided silicon on insulator (SOI) substrate comprising two silicon substrate layers bonded to one another by an insulator layer, for example.

Flowchart 800 continues with an optional action 815 of forming a silicon epitaxial layer or layers over the second side of the silicon substrate. According to the implementation shown in Figure 8, an epitaxial silicon layer or layers are formed over the second side of the silicon substrate. Formation of the epitaxial silicon layer(s) may be performed by any suitable method, as known in the art, such as chemical vapor deposition (CVD) or molecular beam epitaxy (MBE), for example. The epitaxial silicon layer(s) may include one or more layers of N-, N+, P- or P+ conductivity. However, it is noted that in other implementations, other forms of silicon epitaxial layers known in the art may be suitable.

More generally, formation of an epitaxial silicon layer or layers corresponds to formation of any suitable group IV semiconductor body over the second side of the silicon substrate. Thus, in other implementations, the epitaxial silicon layer(s) may correspond to more than one layer, and/or need not be formed of silicon. For example, in one implementation, the epitaxial layer(s) may be formed as either a strained or unstrained germanium layer formed on the second side of the silicon substrate. Moreover, the conductivity type of the epitaxial layer(s) may be appropriately adapted according to the conductivity type of the semiconductor substrate and the particular group IV semiconductor devices to be fabricated. In addition, it may also be preferred to form additional epitaxial silicon or group IV layers over the first side of the silicon substrate.

Flowchart 800 continues with action 820 and forming a III-Nitride semiconductor body over the second side of the silicon substrate or over the optional epitaxial silicon layer(s) if formed in actions 810 and/or 815. In preparation for forming the III-Nitride layers over the second side of the silicon substrate, it may be preferred to protect the first side of the silicon wafer with one or more protective coatings, for example silicon oxide, silicon nitride or a combination of the two. The III-Nitride semiconductor body may include a plurality of III-Nitride layers, which may include a transition layer, a gallium nitride (GaN) layer, and an aluminum gallium nitride (AlGaN) layer, for example. The transition layer may itself correspond to two or more distinguishable layers mediating the lattice transition from the silicon substrate (or silicon epitaxial layers formed over the second side of the silicon substrate if used) to the GaN layer or other III-Nitride layer compositions, as discussed in Figures 1 and 2.

Although the implementations of flowchart 800 refer to III-Nitride semiconductor body, more generally, the semiconductor body may be formed from any suitable group III-V semiconductor materials, as described in the "Definitions" section above. Additionally, after completion of the formation of the III-Nitride semiconductor body, it may be preferred to protect the III-Nitride semiconductor body during subsequent processing actions associated with flowchart 800. For example, a protective silicon nitride layer may be formed in-situ immediately after the termination of III-Nitride growth over the III-Nitride body or may be formed ex-situ using common nitride deposition techniques common in the art including for example, Plasma-Enhanced Chemical Vapor Deposition (PECVD) or Low Pressure Chemical Vapor Deposition (LPCVD). In other implementations, an oxide layer (e.g., silicon oxide) may additionally be formed over the protective silicon nitride layer to provide further protection for the III-Nitride body.

Flowchart 800 continues with the optional action 830 and the formation of epitaxial silicon layer or layers over the first side of the silicon substrate. According to the implementation shown in Figure 8, the optional epitaxial silicon layer(s) are formed over the first side of the silicon substrate. As discussed above in action 810, formation of the epitaxial silicon layer (or more generally group IV layer) may be performed by any suitable method, as known in the art, and may be formed with a conductivity type appropriately adapted according to the conductivity type of the semiconductor substrate and the particular semiconductor devices to be fabricated.

Referring once again to Figure 8, flowchart 800 continues with action 840 and processing of the epitaxial silicon layer or layers to fabricate one or more group IV semiconductor devices and/or integrated circuits, and processing of the III-Nitride body to fabricate one or more III-Nitride devices, for example III-Nitride HEMTs. The processing of the group IV device(s) and III-Nitride device(s) may be performed seperately and completlely as discussed in Figure 2, using an integrated process flow and alternating certain process actions required to form the group IV device(s) and III-Nitride device(s), or processing both the III-Nitride and group IV devices simultanously. It is during this action (840) that any protective coating or layers may need to be partailly or completely removed from the first side of the silicon substrate and the the surface of the III-Nitride body. It may also be necessary to reform and remove additional protective coatings iteratively depending on the process flow required to form both the group IV devices and the III-Nitride devices.

Following fabrication of the group IV and group III-V devices as discussed in action 840, electrical interconnects for the monolithcally integrated structure are formed. Thus, flowchart 800 continues with action 850 and electrically coupling the group IV and III-Nitride devices. This is accomplished using the same methodioligies discussed above in action 260 of Figure 2.

Thus, implementations of the present inventive concepts provide a monolithic vertically integrated device including a group III-V device and a group IV device and/or IC. By utilizing a vertical topology to monolithically integrate group III-V and group IV devices and/or IC, implementations of the present inventive concepts provide a low cost, compact composite device structure. In addition, by utilizing substrate and/or through-wafer vias to electrically couple the group III-V and group IV devices and/or IC, the present disclosure provides a composite device structure having enhanced reliability, reduced parasitics, simplified packaging requirements and lower cost Moreover, by fabricating the group III-V and group IV devices and/or IC on a common semiconductor substrate, the present application enables better group III-V and group IV device matching, thereby resulting in improved composite device performance.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described above, but many rearrangements, modifications, and substitutions are possible without departing from the scope of the present disclosure.

## Claims

1. A monolithic vertically integrated composite device comprising:
a group IV diode fabricated in a group IV semiconductor body formed over a first side of a double sided substrate;
a group III-V device fabricated in a group III-V semiconductor body formed over a second side of said double sided substrate opposite said first side;
said group IV diode being electrically coupled to said group III-V device.

2. The monolithic vertically integrated composite device of claim 1, wherein said group IV diode comprises a PN junction diode.

3. The monolithic vertically integrated composite device of claim 1, wherein said group IV diode comprises an anti-parallel clamp.

4. The monolithic vertically integrated composite device of claim 1, wherein said group IV diode is electrically coupled to said group III-V device by a through-wafer via and/or a substrate via.

5. The monolithic vertically integrated composite device of claim 1, wherein an anode of said group IV diode is electrically coupled to a source of said group III-V device.

6. The monolithic vertically integrated composite device of claim 1, wherein a cathode of said group IV diode is electrically coupled to a drain of said group III-V device.

7. The monolithic vertically integrated composite device of claim 1, wherein said group III-V device comprises a III-Nitride device.

8. The monolithic vertically integrated composite device of claim 1, wherein said monolithic vertically integrated composite device further includes a group IV field-effect transistor.

9. A monolithic vertically integrated composite device comprising:
a group IV field-effect transistor (FET) fabricated in a group IV semiconductor layer formed over a first side of a double sided substrate;
a group III-V device fabricated in a group III-V semiconductor body formed over a second side of said double sided substrate opposite said first side;
said group IV FET being electrically coupled to said group III-V device.

10. The monolithic vertically integrated composite device of claim 9, wherein said group IV FET is electrically coupled to said group III-V device by a through-wafer via and/or a substrate via.

11. The monolithic vertically integrated composite device of claim 9, wherein said group IV FET comprises a silicon FET.

12. The monolithic vertically integrated composite device of claim 9, wherein said group III-V device comprises a III-Nitride device.

13. The monolithic vertically integrated composite device of claim 9, wherein said monolithic vertically integrated composite device further includes a group IV diode.

14. A monolithic vertically integrated composite device comprising:
an integrated circuit (IC) fabricated in a group IV layer formed over a first side of a double sided substrate;
at least one group III-V device fabricated in a group III-V semiconductor body formed over a second side of said double sided substrate opposite said first side;
said IC being electrically coupled to said at least one group III-V device.

15. The monolithic vertically integrated composite device of claim 14, wherein said IC is used to control a conductive state of said at least one group III-V device through modulation of a voltage applied to a gate of said at least one group III-V device.
